# EUROPEAN PATENT SPECIFICATION

(11) **EP 2 553 233 B1**
(45) Date of publication and mention of the grant of the patent: **16.08.2023**
(21) Application number: 11763446.9
(22) Date of filing: 31.03.2011
(51) Int. Cl.: F02B 5/02, B08B 7/02, H01L 21/677, H01L 21/67

(54) **WET BENCH APPARATUS**
NASSBANKVORRICHTUNG
APPAREIL A BANC HUMIDE

(30) Priority: 31.03.2010 US 319824 P
(43) Date of publication of application: 06.02.2013
(73) Proprietor: ATS Automation Tooling Systems Inc., Cambridge, Ontario N3H 4R7 (CA)
(72) Inventor: PAULMAN, Jason, Corvallis, Oregon 97330 (US); SMITH, Bruce, Corvallis, Oregon 97330 (US); SOHN, Raymond, Corvallis, Oregon 97330 (US)
(74) Representative: Wynne-Jones IP Limited
(86) International application number: PCT/US2011/030756
(87) International publication number: WO 2011/123663

(56) References cited:
- US-A- 4 591 402
- US-A- 4 591 402
- US-A- 5 419 058
- US-A- 5 419 058
- US-A- 5 679 055
- US-A- 6 138 694
- US-A1- 2001 005 489
- US-A1- 2001 049 204
- US-A1- 2002 179 127
- US-A1- 2003 113 189
- US-A1- 2003 121 535
- US-A1- 2003 230 384
- US-A1- 2004 129 300
- US-A1- 2004 188 386
- US-A1- 2004 206 379
- US-A1- 2004 253 087
- US-B1- 6 235 634
- ''Wet bench' robot systems' ST ROBOTICS INFORMATION PAGE, [Online] 17 May 2008, Retrieved from the Internet: <URL:http://web.archive.org/web/20080517091 449/http://www.strobotics.com/wetbench.htm> [retrieved on 2011-05-19]
- CONG ET AL.: 'Wafer-Handling Robots and Applications' RECENT PATENTS ON ENGINEERING, [Online] vol. 3, no. 3, December 2009, pages 170 - 177 Retrieved from the Internet: <URL:URL: http://www.benthamscience.com/eng/samples/e ng3-3.tar/0002ENG.pdf> [retrieved on 2011-05-19]

## Description

### FIELD

This application relates to a wet bench apparatus and method for treating articles by immersion in various tanks containing liquids. In particular, this application relates to a wet bench for treating articles such as silicon wafers and gravel.

### BACKGROUND

A wet bench apparatus is used to treat articles typically placing the articles into a series or sequence of tanks containing different chemical compositions. In particular, the wet bench assembly may consist of multiple tanks. In a chemical etching procedure, an article may be dipped in the first tank containing an acidic chemical, and then moved to a subsequent tank containing water to rinse the acidic chemical, in may then be moved to an area for air drying and/or vacuum drying. To move the articles, an over-head crane or gantry is used which has hooks to pick up cassettes or mesh cages containing the articles being treated, for example wafers and/or silicon gravel. In particular, the wafers may be silicon wafers for, for example photovoltaic (PV) applications.

Known wet bench systems are typically only well suited for operation in a sequential fashion where articles advance along consecutive baths in order. For example, a single over-head crane can move cassettes or mesh cages containing the articles sequentially from a first tank to a second tank and then to a drying station. However, where spatial constraints are imposed and/or the articles have to be moved for example from the first bath to the second bath, and then back to the first bath, known wet bench systems are not advantageous.

Other methods in the past use either a return route external to the bench, or require the main gantry to be used for the return.

US2001/049204 discloses a liquid processing apparatus for applying liquid processing to wafers. The wafers are transferred between several liquid processing tanks using a transfer device. However, the wafers are moved within each tank for liquid processing, by a separate transfer device and as such, it is necessary to transfer the wafers between the separate transfer devices. This similarly impose a spatial constraint on the size of the apparatus, given the number of separate transfer devices and also requires careful alignment and handling of the wafers as they are transferred between the separate transfer devices. As such, there is need for an improved system and apparatus for and method of operating a wet bench.

US2004/129300 discloses a substrate processing apparatus comprising two substrate transporting devices which are arranged to move along a path for transporting substrates along a processing tank. The transporting devices are arranged to move along an identical path, along overlapping ranges, according to scheduling data created by a scheduler. The scheduling data is based on processing conditions and transporting conditions for controlling the operation of the transportation device, which are entered in advance.

### SUMMARY

This application is directed to a wet bench apparatus which can provide for continuous rack and pinion motion with multiple robots mounted on a single linear axis to work in a wet bench with overlapping work areas.

This application also provides for leap frog motion whereby the platform uses two linear motion rails along the length of the wet bench on opposite sides of the tanks from each other. This arrangement can allow robots to move past one another within the wet bench and can reduce cycle time and can also prevent a potentially acid-contaminated part from being removed from the safety of a fume and drip containment of the wet bench for return to the beginning.

In one aspect, a wet bench apparatus is provided, comprising: a container; and a first robot comprising: a first arm movable in a horizontal direction of a container; a first cam follower system configured to move the first arm horizontally; and a second robot comprising: a second arm movable in the horizontal direction of the container; a second cam follower system configured to move the second arm horizontally; wherein the first arm and the second arm are adapted to move items vertically; characterised in that the first cam follower system comprises at least one cam roller positioned between a first guide bar and a second guide bar and configured to resist moment from the first arm of the first robot; the second cam follower system comprises at least one cam roller positioned between a first guide bar and a second guide bar and configured to resist moment from the second arm of the second robot; the second arm is adapted to move past the first arm; and wherein the first arm and at least one first item are positionable in a user specified orientation to move without contacting the second arm and the at least one second item.

In a preferred case, the first arm and the second arm are positioned on opposite sides of the container.

In a preferred case, the first robot is movable on a first track and the second robot is movable on a second track.

In a preferred case, the first and second robots, the first and second arms, and the first and second tracks are made of corrosion resistant material.

In another aspect, a wet bench system is provided, comprising the apparatus according to the first aspect, the system further comprising: a first rail positioned generally horizontally adjacent a first side of the container, the first arm and the first robot moveable on the first rail; and a second rail positioned generally horizontally adjacent a second side of the container, the second arm and the second robot moveable on the second rail.

In a preferred case, the first and second arms are also movable in a vertical direction.

In a preferred case, the first arm has a first end effector connected to a second end of the first arm opposite to the first end, and the second arm has a second end effector connected to a second end of the second arm opposite to the first end.

In a preferred case, a second container is positioned proximate to the first container in the horizontal direction and wherein the first arm is operable to move at least one first item and the second arm is operable to move at least one second item from the first container to the second container.

According to the invention, the first robot has a first cam follower system comprising at least one cam roller positioned between a first guide bar and a second guide bar, and the second robot has a second cam follower system comprising at least one cam roller positioned between a third guide bar and a fourth guide bar.

In a preferred case, the first robot has a first cam follower system comprising a first cam roller positioned on one side of a guide bar and a second cam roller positioned on an opposite side of the guide bar, and the second robot has a second cam follower system comprising a first cam roller positioned on one side of a guide bar and a second cam roller positioned on an opposite side of the guide bar.

In a preferred case, the first and second robots, the first and second arms, and the first and second tracks are made of corrosion resistant material.

Other aspects and features will become apparent to those ordinarily skilled in the art upon review of the following description of specific embodiments in conjunction with the accompanying figures.

### BRIEF DESCRIPTION OF FIGURES

For a better understanding of the embodiments described herein and to show more clearly how they may be carried into effect, reference will now be made, by way of example only, to the accompanying drawings which show the exemplary embodiments and in which:
Figure 1 shows an end view of a "leap frog" robot arm system with one arm shown raised to clear second arm;
Figure 2 shows a cam follower system having a double guide bar arrangement;
Figure 3 shows a cam follower system having a single guide bar arrangement;
Figure 4 shows a system with multiple robots on the same linear axis; and
Figure 5 shows multiple cable tracks for other robots.

### DETAILED DESCRIPTION

It will be appreciated that for simplicity and clarity of illustration, where considered appropriate, reference numerals may be repeated among the figures to indicate corresponding or analogous elements or steps. In addition, numerous specific details are set forth in order to provide a thorough understanding of the exemplary embodiments described herein. However, it will be understood by those of ordinary skill in the art that the embodiments described herein may be practiced without these specific details. In other instances, well-known methods, procedures and components have not been described in detail so as not to obscure the embodiments described herein. Furthermore, this description is not to be considered as limiting the scope of the embodiments described herein in any way, but rather as merely describing the implementation of the various embodiments described herein.

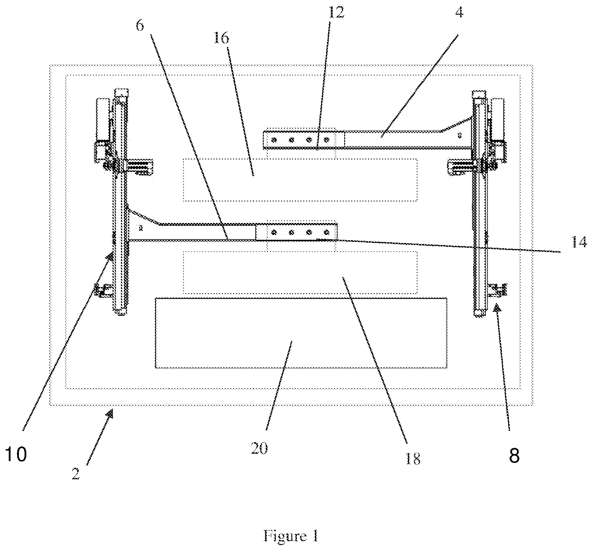

Figure 1 shows an end view of a "leap frog" robot arm system 2 with a first arm 4 vertically raised to clear second arm 6. As shown, the system 2 uses a first robot 8 positioned on one side of the process tank, and a second robot 10 positioned on an opposite side of the process tank, to move respective arms 4 and 6. As shown, the first arm 4 has a first end effector 12 positioned thereon. The second arm 6 has a second end effector 14 positioned thereon.

The first end effector 12 is shown lifting a first product 16. The second end effector is shown lifting a second product 18. Preferably, the first product 16 and the second product 18 are silicon wafers or gravel. As shown, the first arm 4 and product 16 are lifted vertically so as to clear the second arm 6, when the respective first and second arms 4, 6 are moved in a horizontal direction in or out of the page.

Also shown in Figure 1 is a process tank 20 which can contain chemicals into which the first product 16 and/or second product 18 can be placed for processing the product.

Each of the first and second robots, 8 and 10, preferably has two servo-controlled axis: (a) a Z-axis that is long enough to place the product in the process tanks and to pass over the second robot while carrying product; and (b) an X-axis that runs a length of the wet bench system.

The first and second robot arms, 4 and 6, can be made of coated stainless steel, such as Teflon^{™} coated stainless steel. The linear motion rails and the rack and pinion system can be coated with a black chrome coating impregnated with Teflon^{™}, such as Raydent^{™}. These components may then be coated with a Teflon^{™} based grease such as DuPont Krytox^{™} to increase corrosion protection. Preferably, the motors on the robots are chemical duty motors with air purge.

The system 2 having the first robot arm 4 and second robot arm 6 which can be vertically off-set from each other is advantageous in enabling moving items from bath tank to bath tank without requiring handing off from one robot arm to another. Further, the vertically off-set robot arms, 4 and 6, advantageously increase throughput of the process and avoid time consuming steps such as handing off or the need for a staging area to set one cage down and pick another up.

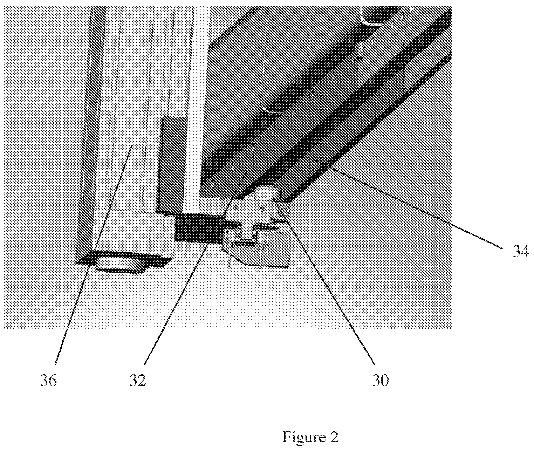

Figure 2 shows a cam follower system having a single rack as the motion backbone for multiple robots. The cam follower system of Figure 2 has a double guide bar arrangement whereby a set of cam rollers 30 run between a first guide bar 32 and a second guide bar 34. Preferably, the guide bar arrangement is made of corrosion resistant or coated material. An upper rail (not shown) supports the robot, and the cam rollers 30 are provided to resist moment. Preferably, at least three rollers are provided in the set of cam rollers 30. The double guide bar arrangement protects the rollers 30 from drips.

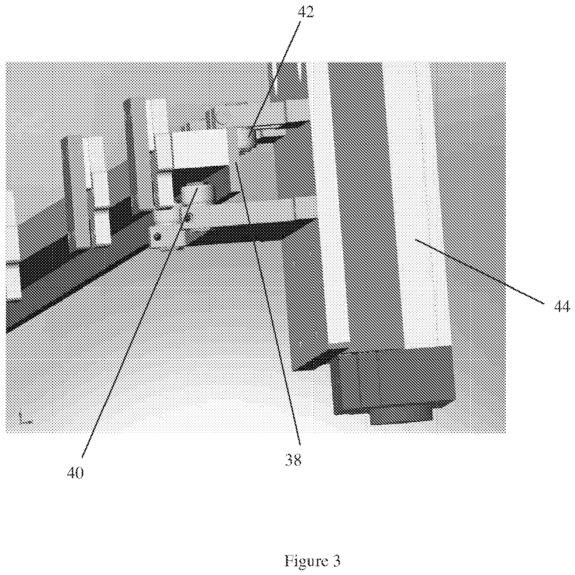

Figure 3 shows a cam follower system having a single bar arrangement. As shown, a single bar 38 is provided with a first roller set 40 on one side of the bar 38, and a second roller set 42 on an opposite side of the bar 38. A robot 44 is attached to an upper rail (not shown) and the first roller set 40 and the second roller set 42 are provided to resist moment. Preferably, the linear guide system for the lower portion of the linear axis is low-cost and easily replaceable.

To resist corrosion, the components of the cam follower system shown in Figures 2 and 3 can be coated with a corrosion resistant coating. For example, the corrosion resistant coating may be Raydent^{™}, Armalloy^{™}, or NiCoTef^{™}. Preferably, the robots 36 and 44 carry their own pinion and drive motor. Each robot 36 and 44 can pull a cable chain to supply it with compressed air, communications, and electricity, as desired.

In the arrangements shown in Figures 2 and 3, a moment from the long arm of the robot is resisted by the cam follower system. Preferably, the cam follower systems are a simple linear track mounted near the base of the wall. As these parts are generally positioned closer to a treatment bath tank, they may be deteriorated by fumes from the bath, and therefore are preferably made inexpensive and easy to replace.

Also, the segmented rack and rail design allows for very long travel. The system shown can have a rail length of approximately 22,000 mm, or just over 72 feet.

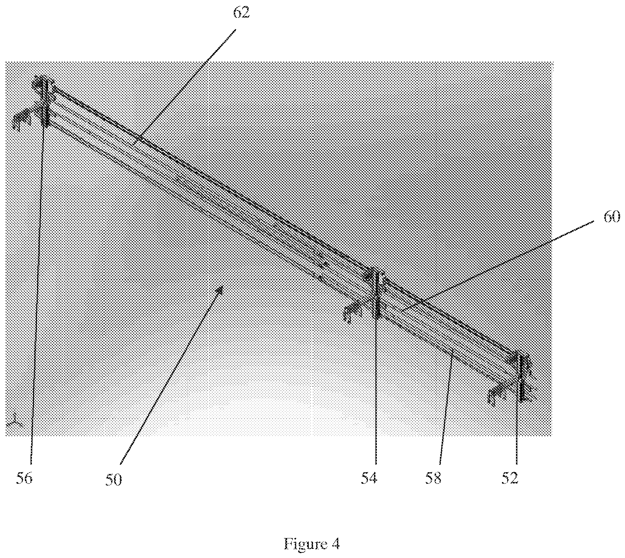

Figure 4 shows a system 50 with multiple robots on the same linear axis. The robot system 50 has a first robot 52, a second robot 54, and a third robot 56. A respective cable track 58, 60, and 62 is run for each of the respective first robot 52, second robot 54, and third robot 56 in the system 50.

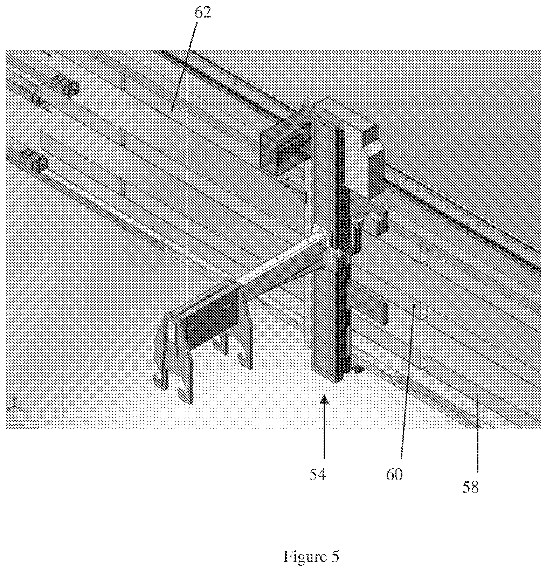

Figure 5 shows the middle robot 54 of Figure 4, as well as multiple cable tracks for other robots.

Although this disclosure has described and illustrated certain embodiments, it is also to be understood that the system, apparatus and method described is not restricted to these particular embodiments, while the scope of the invention is defined by the claims.

## Claims

1. A wet bench apparatus, comprising:
a container (20); and
a first robot (8, 52) comprising:
a first arm (4) movable in a horizontal direction of the container; a second robot (10, 54) comprising:
a second arm (6) movable in the horizontal direction of the container, wherein the first arm (4) and the second arm (6) are adapted to move items vertically, **characterized in that**
the second arm (6) is adapted to move past the first arm (4)
wherein the wet bench apparatus further comprises a first cam follower system configured to move the first arm (4) horizontally, the first cam follower system comprising at least one cam roller (40, 42) positioned between a first guide bar (32) and a second guide bar (34) and configured to resist moment from the first arm (4) of the first robot (8,52); and a second cam follower system configured to move the second arm (6) horizontally, wherein the second cam follower system comprises at least one cam roller (40, 42) positioned between a third guide bar (32) and a fourth guide bar (34) and configured to resist moment from the second arm (6) of the second robot (10, 54);
wherein the first arm (4) and at least one first item (16) are positionable in a user specified orientation to move without contacting the second arm (6) and at least one second item (18).

2. The wet bench apparatus of claim 1, wherein the first arm (4) and the second arm (6) are positioned on opposite sides of the container (20).

3. The wet bench apparatus of claim 2, wherein the first robot (8, 52) is movable on a first track (58), the second robot (10, 54) is movable on a second track (60).

4. A wet bench system (2, 50), comprising the wet bench apparatus of claim 1, the wet bench system (2, 50) further comprising:
a first rail positioned generally horizontally adjacent a first side of the container (20), the first arm (4) and the first robot (8, 52) moveable on the first rail; and
a second rail positioned generally horizontally adjacent a second side of the container (20), the second arm (6) and the second robot (10, 54) moveable on the second rail.

5. The wet bench system (2, 50) of claim 4, wherein the first and second arms (4,6) are also movable in a vertical direction.

6. The wet bench system (2, 50) of claims 4 or 5, wherein the first arm (4) has a first end effector (12) connected to a second end of the first arm (4) opposite to the first end, and the second arm (6) has a second end effector (14) connected to a second end of the second arm (6) opposite to the first end.

7. The wet bench system (2, 50) of any one of claims 4 to 6, comprising a first container and a second container, the second container being positioned proximate to the first container (20) in the horizontal direction and wherein the first arm (4) is operable to move at least one first item (16) and the second arm (6) is operable to move at least one second item (18) from the first container (20) to the second container.

8. The wet bench system (2, 50) of any one of claims 4 to 6, wherein the first and second robots (8, 10, 52, 54), the first and second arms (4, 6), and first and second tracks (58, 60) are made of corrosion resistant material.

## Patentansprüche

1. Nassbankvorrichtung, umfassend:
einen Behälter (20); und
einen ersten Roboter (8, 52), umfassend:
einen ersten Arm (4), der in einer horizontalen Richtung des Behälters beweglich ist;
einen zweiten Roboter (10, 54), umfassend:
einen zweiten Arm (6), der in der horizontalen Richtung des Behälters beweglich ist, wobei der erste Arm (4) und der zweite Arm (6) angepasst sind, um Gegenstände vertikal zu bewegen, **dadurch gekennzeichnet, dass** der zweite Arm (6) angepasst ist, um sich an dem ersten Arm (4) vorbei zu bewegen;
wobei die Nassbankvorrichtung ferner ein erstes Nockenstößelsystem umfasst, das konfiguriert ist, um den ersten Arm (4) horizontal zu bewegen, wobei das erste Nockenstößelsystem mindestens eine Nockenwalze (40, 42) umfasst, die zwischen einer ersten Führungsleiste (32) und einer zweiten Führungsleiste (34) positioniert und konfiguriert ist, um dem Moment von dem ersten Arm (4) des ersten Roboters (8,52) zu widerstehen; und ein zweites Nockenstößelsystem, das konfiguriert ist, um den zweiten Arm (6) horizontal zu bewegen, wobei das zweite Nockenstößelsystem mindestens eine Nockenwalze (40, 42) umfasst, die zwischen einer dritten Führungsleiste (32) und einer vierten Führungsleiste (34) positioniert und konfiguriert ist, um dem Moment von dem zweiten Arm (6) des zweiten Roboters (10, 54) zu widerstehen;
wobei der erste Arm (4) und mindestens ein erster Gegenstand (16) in einer benutzerspezifizierten Ausrichtung positionierbar sind, um sich zu bewegen, ohne den zweiten Arm (6) und mindestens einen zweiten Gegenstand (18) zu berühren.

2. Nassbankvorrichtung nach Anspruch 1, wobei der erste Arm (4) und der zweite Arm (6) auf gegenüberliegenden Seiten des Behälters (20) positioniert sind.

3. Nassbankvorrichtung nach Anspruch 2, wobei der erste Roboter (8, 52) auf einer ersten Bahn (58) bewegbar ist, der zweite Roboter (10, 54) auf einer zweiten Bahn (60) bewegbar ist.

4. Nassbanksystem (2, 50), umfassend die Nassbankvorrichtung nach Anspruch 1, das Nassbanksystem (2, 50) ferner umfassend:
eine erste Schiene, die im Allgemeinen horizontal neben einer ersten Seite des Behälters (20) positioniert ist, wobei der erste Arm (4) und der erste Roboter (8, 52) auf der ersten Schiene beweglich sind; und
eine zweite Schiene, die im Allgemeinen horizontal neben einer zweiten Seite des Behälters (20) positioniert ist, wobei der zweite Arm (6) und der zweite Roboter (10, 54) auf der zweiten Schiene beweglich sind.

5. Nassbanksystem (2, 50) nach Anspruch 4, wobei der erste und der zweite Arm (4, 6) auch in einer vertikalen Richtung bewegbar sind.

6. Nassbanksystem (2, 50) nach Anspruch 4 oder 5, wobei der erste Arm (4) einen ersten Endeffektor (12) aufweist, der mit einem zweiten Ende des ersten Arms (4) gegenüber dem ersten Ende verbunden ist, und der zweite Arm (6) einen zweiten Endeffektor (14) aufweist, der mit einem zweiten Ende des zweiten Arms (6) gegenüber dem ersten Ende verbunden ist.

7. Nassbanksystem (2, 50) nach einem der Ansprüche 4 bis 6, umfassend einen ersten Behälter und einen zweiten Behälter, wobei der zweite Behälter in der horizontalen Richtung in der Nähe des ersten Behälters (20) positioniert ist und wobei der erste Arm (4) betriebsfähig ist, um mindestens einen ersten Gegenstand (16) zu bewegen, und der zweite Arm (6) betriebsfähig ist, um mindestens einen zweiten Gegenstand (18) von dem ersten Behälter (20) in den zweiten Behälter zu bewegen.

8. Nassbanksystem (2, 50) nach einem der Ansprüche 4 bis 6, wobei der erste und der zweite Roboter (8, 10, 52, 54), der erste und der zweite Arm (4, 6) und die erste und die zweite Schiene (58, 60) aus korrosionsbeständigem Material hergestellt sind.

## Revendications

1. Appareil de banc humide, comprenant :
un récipient (20) ; et
un premier robot (8, 52) comprenant :
un premier bras (4) mobile dans une direction horizontale du récipient ;
un second robot (10, 54) comprenant :
un second bras (6) mobile dans la direction horizontale du récipient, dans lequel le premier bras (4) et le second bras (6) sont adaptés pour déplacer les articles verticalement, **caractérisé en ce que** le second bras (6) est adapté pour se déplacer au-delà du premier bras (4) ;
dans lequel l'appareil de banc humide comprend en outre un premier système suiveur de came conçu pour déplacer le premier bras (4) horizontalement, le premier système suiveur de came comprenant au moins un galet de came (40, 42) positionné entre une première barre de guidage (32) et une deuxième barre de guidage (34) et conçu pour résister à un moment à partir du premier bras (4) du premier robot (852) ; et un second système suiveur de came conçu pour déplacer le second bras (6) horizontalement, dans lequel le second système suiveur de came comprend au moins un galet de came (40, 42) positionné entre une troisième barre de guidage (32) et une quatrième barre de guidage (34) et conçu pour résister à un moment du second bras (6) du second robot (10, 54) ;
dans lequel le premier bras (4) et au moins un premier élément (16) peuvent être positionnés dans une orientation spécifiée par l'utilisateur pour se déplacer sans venir en contact avec le second bras (6) et au moins un second élément (18).

2. Appareil de banc humide selon la revendication 1, dans lequel le premier bras (4) et le second bras (6) sont positionnés sur des côtés opposés du récipient (20).

3. Appareil de banc humide selon la revendication 2, dans lequel le premier robot (8, 52) est mobile sur une première piste (58), le second robot (10, 54) est mobile sur une seconde piste (60).

4. Système de banc humide (2, 50), comprenant l'appareil de banc humide selon la revendication 1, le système de banc humide (2, 50) comprenant en outre :
un premier rail positionné généralement horizontalement adjacent à un premier côté du récipient (20), le premier bras (4) et le premier robot (8, 52) pouvant être déplacés sur le premier rail ; et
un second rail positionné généralement horizontalement adjacent à un second côté du récipient (20), le second bras (6) et le second robot (10, 54) étant mobiles sur le second rail.

5. Système de banc humide (2, 50) selon la revendication 4, dans lequel les premier et second bras (4,6) sont également mobiles dans une direction verticale.

6. Système de banc humide (2, 50) selon les revendications 4 ou 5, dans lequel le premier bras (4) présente un premier effecteur terminal (12) relié à une seconde extrémité du premier bras (4) opposée à la première extrémité, et le second bras (6) a un second effecteur terminal (14) relié à une seconde extrémité du second bras (6) opposée à la première extrémité.

7. Système de banc humide (2, 50) selon l'une quelconque des revendications 4 à 6, comprenant un premier récipient et un second récipient, le second récipient étant positionné à proximité du premier récipient (20) dans la direction horizontale et le premier bras (4) pouvant fonctionner pour déplacer au moins un premier élément (16) et le second bras (6) pouvant fonctionner pour déplacer au moins un second élément (18) du premier récipient (20) vers le second récipient.

8. Système de banc humide (2, 50) selon l'une quelconque des revendications 4 à 6, dans lequel les premier et second robots (8, 10, 52, 54), les premier et second bras (4, 6) et les première et seconde pistes (58, 60) sont réalisés en matériau résistant à la corrosion.
